# EUROPEAN PATENT APPLICATION

(11) **EP 2 629 592 A1**
(43) Date of publication of application: **21.08.2013**
(21) Application number: 12305168.2
(22) Date of filing: 15.02.2012
(51) Int. Cl.: H05K 5/02, H01Q 1/24

(54) **Connection box, main box, and base station transceiver**

(71) Applicant: Alcatel Lucent, 75007 Paris (FR)
(72) Inventor: Neustadt, Alf, 70180 Stuttgart (DE)
(74) Representative: 2SPL Patentanwälte

(57) **Abstract**

Embodiments provide a connection box, a main box, and a base station transceiver. The connection box 10 of the base station transceiver 100 is operable for connecting a backhaul processing component of the base station transceiver 100 to a backhaul access system of a mobile communication system. The connection box 10 comprises a housing 12 for an electronic backhaul processing component of the base station transceiver 100 of the mobile communication system and means for mounting 14 a main box 20 with a front end processing component of the base station transceiver 100 of the mobile communication system. The main box 20 comprises a housing 22 for an electronic front end processing component of the base station transceiver 100 and means for attaching 24 the main box 20 to the connection box 10 with the backhaul processing component of the base station transceiver 100.

## Description

Embodiments of the present invention relate to radio transceivers, more particularly but not exclusively to transceivers for small cells.

### Background

Demands for higher data rates for mobile services are steadily increasing. At the same time modern mobile communication systems as 3rd Generation systems (3G) and 4th Generation systems (4G) provide enhanced technologies which enable higher spectral efficiencies and allow for higher data rates and cell capacities. As operators are seeking to extend the coverage and capacity of their networks, deployment of heterogeneous cells is one way forward.

In mobile communication networks heterogeneous architectures become more and more important. Heterogeneous Networks (HetNets) are networks which utilize cell types of different sizes, as, for example, macro cells, small cells, pico cells, metro cells, and femto cells. Such cells are established by base station transceivers for which their coverage areas are determined by their transmission power and interference condition. Pico cells and femto cells are cells having a smaller coverage area than macro cells. In some network scenarios the small cells' coverage area can be surrounded by the coverage area of a macro cell. The small cells can be deployed to extend the capacity of the network. With regard to standardization, within the 3rd Generation Partnership Project (3GPP), HetNets have been added to the scope of the Long Term Evolution-Advanced (LTE-A) work item.

HetNet deployment is used to increase the system capacity and to handle a large amount of traffic especially at hot spots such as town centers. Small cells, e.g. pico cells or metro cells, can be deployed in these hot spots. A metro cell may correspond to a small cell having a smaller coverage area than a macro cell. The name "metro" is based on application of such small cells in metropolitan areas to extend the capacity of macro cells in such areas. Thus, macro cells may have the largest coverage area, e.g. 100m-1000m in diameter, small cells (pico cell and metro cell are synonymous) may have a medium coverage area, such as 10m- 200m in diameter, and femto cells may have the smallest coverage area, e.g. 1-50m. A macro cell can balance the load in the system by offloading mobile transceivers or User Equipment (UEs) to small cells, when the UEs are in the vicinity of a small or pico cell. The offloaded UEs can then be serviced by the small cell with high throughput, especially when the pico cell is operative at a different frequency layer than the macro cell.

### Summary

Embodiments are based on the finding that the small cell concept may be made more efficient by detachable base station transceivers, for example, by detachable pico or metro cells or base station transceivers. Embodiments may provide a metro Base Transceiver Station (BTS) as a small base station or cell. The room or volume of such a metro BTS can be around 3-131. Such a detachable metro BTS can be deployed close to the users, e.g. in streets on light poles or on walls of buildings. Embodiments can be further based on the finding that such a deployment may make the BTS much more visible than traditional macro BTS, which are usually mounted at higher locations, such as roof tops, tall masts, etc.

It is a finding that it may be advantageous to have an installation principle, which can allow hiding cables and other visible 'technical' devices. It may also be desirable to keep the size of the BTS and any mounting devices as small as possible. Considering that small cell deployment can be linked to deployment of a large number of base station transceivers, it may be advantageous if installation of these base station transceivers was fast and simple, and in case of a repair or upgrade, if the replacement was possible in short time with a low or minimum number of tools and preferably without safety concerns.

Embodiments are based on the finding that a base station transceiver can be subdivided into two parts. The base station transceiver can be composed of a connection box and a main box. The connection box can comprise components which connect to the backhaul network, while the main box comprises components which establish the radio interface. The two boxes or housings can then be mounted together using respective mechanical and electrical couplings.

Embodiments provide a connection box of a base station transceiver for connecting a backhaul processing component of the base station transceiver to a backhaul access system for a mobile communication system. The connection box comprises a housing for an electric backhaul processing component of the base station transceiver of the mobile communication system. The connection box further comprises means for mounting a main box with a front end processing component of the base station transceiver of the mobile communication system.

Embodiments further provide the main box of the base station transceiver for connecting the front end processing part of the base station transceiver with the backhaul processing component of the base station transceiver. The main box comprises a housing for the electric front end processing component of the base station transceiver and means for attaching the main box to the connection box with the backhaul processing component of the base station transceiver.

The mobile communication system may, for example, correspond to one of the mobile communication systems standardized by 3GPP, as Global System for Mobile Communications (GSM), Enhanced Data rates for GSM Evolution (EDGE), GSM EDGE Radio Access Network (GERAN), Universal Terrestrial Radio Access Network (UTRAN) or Evolved UTRAN (E-UTRAN), Long Term Evolution (LTE) or LTE-Advanced (LTE-A), or mobile communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. In the following the terms mobile communication system and mobile communication network are used synonymously.

In embodiments, the mobile communication system may comprise mobile transceivers and base station transceivers. A mobile transceiver may correspond to a smartphone, a cell phone, a User Equipment (UE), a laptop, a notebook, a personal computer, a Personal Digital Assistant (PDA), an Universal Serial Bus (USB) -stick, a car, etc. A mobile transceiver may also be referred to as User Equipment (UE) in line with the 3GPP terminology. A base station transceiver can be located in the fixed or stationary part of the network or system. A base station transceiver may correspond to a remote radio head, an access point, a macro cell, a small cell, a micro cell, a femto cell, a metro cell etc. A base station transceiver can be a wireless interface of a wired network, which enables transmission of radio signals to a UE or mobile transceiver. Such a radio signal may comply with radio signals as, for example, standardized by 3GPP or, generally, in line with one or more of the above listed systems. Thus, a base station transceiver may correspond to a NodeB, an eNodeB, a BTS, an access point, etc.

As backhaul access often requires cable wiring, but may not significantly vary over time on a site, the backhaul access can be placed in an embodiment of the so called connection box. In embodiments the connection box may terminate the backhaul and provide cable access for the front end in the main box. Moreover, the connection box may comprise mechanical means to hold the main box in place. Hence, the field installation process may be made more efficient with embodiments of the present invention. When the power and backhaul cables are ready on site the connection box can be attached to a pole or wall. In embodiments the connection box may therefore comprise further mounting equipment for being mounted on said pole or wall. The backhaul cables may then be connected in the connection box. The connection box may therefore comprise an inlet or input for these cables, which can be implemented in a water and/or weather proof manner. Thus, a water proof entry may be made into the connection box, which can then be closed subsequently.

Moreover, the power cable may be attached to the main box and the main box may then be hooked, connected, or installed on the connection box. In embodiments the connection box and the main box may have electrical connectors. For example, the connection box may comprise a common electrical connector for electrically connecting the backhaul processing component of the base station transceiver with the front end processing component of the main box. Correspondingly, in an embodiment, the main box may comprise a common electrical connector for electrically connecting the front end processing component of the base station transceiver with the backhaul processing component in the connection box.

The common electrical connectors can commonly connect data lines and power lines. That is to say, in some embodiments, the common electrical connector may comprise a power supply line, i.e. the main box may provide power to the connection box. In other embodiments, the connection box may provide power supply to the main box, respectively. Moreover, data connections may be established using the common electrical connectors. In embodiments, the common electrical connector can be such that multiple different combinations of connection boxes and main boxes can be coupled to each other using the common electrical connectors. In embodiments, a connection box may be coupled with different main boxes. The different main boxes may differ in their sizes as well as in their implementation. For example, the main boxes may have different sizes in embodiments, the main boxes may have different radio front ends at different radio frequencies, or the main boxes may be compliant to different radio standards. On the side of the connection box, the means for mounting can be adapted accordingly, i.e. the means for mounting may be operable to allow the mounting of the different main boxes. Moreover, the connection boxes may differ in their sizes and compliance to different backhaul networks.

Moreover, embodiments may provide a main box with the front end processing component, which can be operable to be compliant to different radio standards, as for example TDMA, FDMA, OFDMA, WCDMA, LTE, GSM, UMTS, WLAN, WiMAX, etc. In further embodiments, the electronic front end processing component of different main boxes may utilize different horizontal radiation pattern, for example, with 60°, 90°, 180°, or 270° horizontal opening. The horizontal opening may correspond to a half power beam width, i.e. a horizontal beam width of an antenna beam, in which a radiated power has reduced by 3dB compared to the main direction of the beam. The half power beam width may also be referred to as the horizontal aperture or an angular extension of the radiation pattern.

The different options or implementations of the main box show, that embodiments may be flexible. That is to say, the connection box may enable the mounting of different main boxes, and therewith enable a simple mechanism to adapt the network to different frequencies, standards, radiation patterns, cell sizes, load distribution etc. The different main boxes may comprise radio front ends with different transmission powers, resulting in cells of different sizes. A similar adaptation would result, using main boxes with front ends having different horizontal or vertical antenna patterns, in order to achieve a different spatial extension of the network. The concept of having the connection box and a separable main box for a base station transceiver of the mobile communication system can enable additional flexibility with respect to cell and network planning.

As the backhaul of a BTS can vary from site to site, embodiments of the connection box may have different backhaul access versions. Some of them may even need more space than others and/or may have different power consumptions. Therefore, embodiments can be adapted in their size to the respective backhauls access needs. The number of combinations may correspond to the product of the number of different radio BTS and the number of different backhaul access versions. In order to limit the number of different implementations, in embodiments backhaul access function and radio part function can be separated by connection box and main box and a common interface can be defined as common electrical connector.

The common electrical connectors can provide power connections and data connections. The connections can be bidirectional, i.e. data can be transferred from the connection box to the main box, and from the main box to the connection box. The common electrical connectors therewith enable backhaul access for front end components and vice versa. There are different mechanical variances in embodiments of the common electrical connector. In some embodiments, a slot is implemented on each of the connection box and the main box and an intermediate or intermittent board is used in between. In such embodiments, high mechanical tolerance can be achieved, since such an intermediate or intermittent board would have mechanical tolerance in all three spatial dimensions. In other embodiments, other common electrical connectors can be used.

In embodiments, the common electrical connector can be operable to receive supply power from the main box. The common electrical connector may correspond to a Peripheral Component Interconnect express (PCIe) connector. That is to say, a PCIe connector as a physical means may be used in embodiments to connect the connection box and the main box. In some embodiments a PCIe connector may be used on both sides, i.e. at the connection box and at the main box. A PCIe intermediate board can then be used to connect the PCIe connectors. Such a connector can be used as common connector, i.e. in embodiments the common electrical connector can be operable to connect to different front end processing components in different main boxes. In some embodiments, a dome can be located around the common electrical connector, on either or on both sides, i.e. on the connection box and on the main box. Furthermore, a gasket can be located around the common electrical connector, also on either or on both sides. The gasket and the dome can be used to protect the connector, in particular to avoid water or weather influences on the connector. Thus, in embodiments the common electrical connector, on either or both of the connection box and the main box, may comprise weather protection.

In embodiments, different materials can be used for the connecting box and the main box. Embodiments may be implemented in outside areas, such as in town centers, train stations, stadiums, etc. Moreover, embodiments may be used to extend the capacity of communication networks and hot spots, i.e. in areas where high loads and many people occur. Embodiments may therefore also be subject to vandalism, which is why in embodiments robust materials may be used for the connection box and the main box. For example, shock absorbing materials such as plastics or synthetic materials may be used. In further embodiments even vandalism free or resistant materials may be utilized. Moreover, weather resistant materials may be used.

As it has already been mentioned above, embodiments of the connection box may comprise mounting equipment for being mounted on a pole or wall. The housing of the connection box may provide room for electronic backhaul processing components of a small cell or metro base station transceiver. Moreover, the means for mounting of the connection box may comprise at least a part of a locking mechanism for the main box. The part of the locking mechanism can be operable to be securely connected to a counterpart of the locking mechanism at the main box. The locking mechanism can be operable to prevent an unauthorized separation of the connection box and main box comprising the counter part of the locking mechanism. Thus, the locking mechanism may have two advantages. It may prevent unauthorized separation of the connection box and the main box, and it may enable efficient assembly of the connection box and the main box by locking the main box when being brought in a predefined position.

Embodiments may also provide both parts, i.e. the connection box and the main box containing the respective electrical functions (not just a wall mounting kit). The main box may cover the cable access to provide visible and mechanical protection. Embodiments of the main box and/or the connection box may be electrically and mechanically linked in one step. Embodiments may therewith provide the ability to modify each part, the main box and the connection box, without having to change the interface between them. A separation in a radio dependent and a backhaul dependent part can be enabled. Moreover, in further embodiments a separation into safety relevant and non-safety relevant connections can be implemented. Moreover, the power supply for the connection box and the backhaul part can be supplied from the main box.

In embodiments, the common electrical connector on either side may provide the advantage that the connector mechanics may have tolerance in 3 dimensions. Moreover, locking mechanics may prevent from unauthorized separation and for easy assembly.

Embodiments further provide a base station transceiver comprising a connection box and a main box according to the above description. In some embodiments the main box, when mounted on the connection box, may hide the connection box. That is to say, from a perspective, in which the connection box lies behind the main box, the connection box can be completely hidden or shielded by the main box. As it has already been described the base station transceiver may further comprise an intermediate board, which is coupled to the common electrical connector of the connection box and which is coupled to the common electrical connector of the main box. The housing of the connection box and the housing of the main box may form a waterproof surrounding for the intermediate board. The intermediate board may therewith be protected from weather influences by either one or both of the housings. In further embodiments a base station transceiver may be provided as a kit of parts, i.e. it may be provided as a package of a connection box and a main box.

### Brief description of the Figures

Some other features or aspects will be described using the following non-limiting embodiments of apparatuses and/or methods and/or computer programs by way of example only, and with reference to the accompanying figures, in which
Figure 1 shows an embodiment of a connection box and an embodiment of a main box;
Figure 2 shows another embodiment of a connection box and an embodiment of a main box;
Figure 3 illustrates a number of differently shaped embodiments;
Figure 4 illustrates a number of differently shaped embodiments from a different perspective;
Figure 5 shows two embodiments illustrating a common electrical connector;
Figure 6 shows a block diagram representing the electrical components in embodiments;
Figure 7 shows a block diagram representing the electrical components in other embodiments;
Figure 8 illustrates a common electrical connector in an embodiment;
Figure 9 illustrates a mounting and locking mechanism of embodiments; and
Figure 10 illustrates a mounting and locking mechanism of embodiments from another perspective.

### Description of some Embodiments

Various embodiments will now be described in more detail with reference to the accompanying drawings. In the figures, the thicknesses of lines, layers and/or regions may be exaggerated for clarity.

Accordingly, while embodiments are capable of various modifications and alternative forms, embodiments thereof are shown by way of example in the figures and will herein be described in detail. It should be understood, however, that there is no intent to limit embodiments to the particular forms disclosed, but on the contrary, embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

In the following description some components will be displayed in multiple figures carrying the same reference signs, but may not be described multiple times in detail. A detailed description of a component may then apply to that component for all its occurrences.

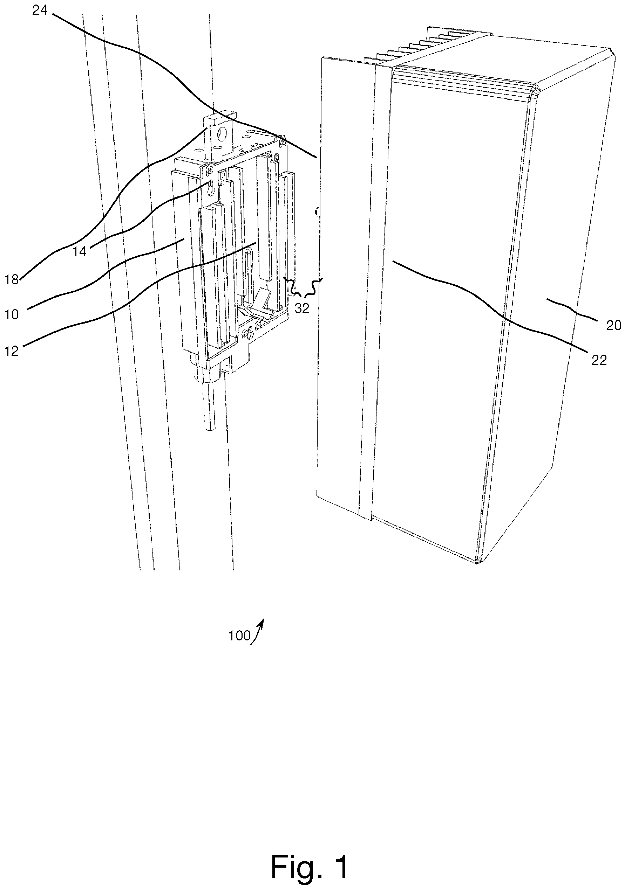

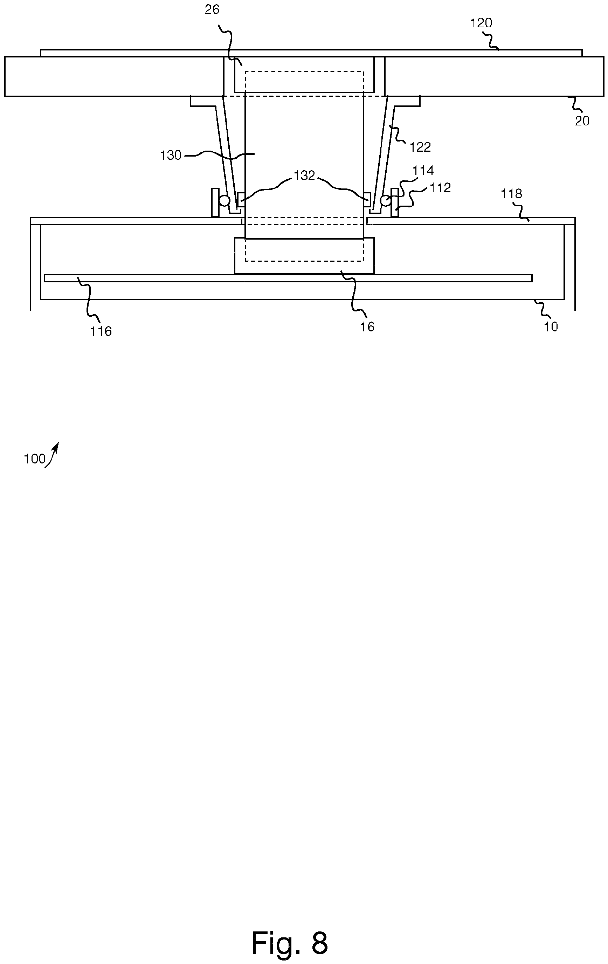

Fig. 1 shows an embodiment of a connection box 10 of a base station transceiver 100 for connecting a backhaul processing component of the base station transceiver 100 to a backhaul access system of a mobile communication system. The base station transceiver 100 is composed of the connection box 10 and a main box 20, which are shown separately in Fig. 1. The connection box 10 comprises a housing 12 for an electronic backhaul processing component of the base station transceiver 100 of the mobile communication system. The connection box 10 further comprises means for mounting 14 the main box 20 with a front end processing component of the base station transceiver 100 of the mobile communication system. The means for mounting 14 will be further detailed subsequently with the help of Figs. 8, 9, and 10.

Fig. 1 further illustrates an embodiment of the main box 20 of the base station transceiver 100 for connecting the front end processing part of the base station transceiver 100 with the backhaul processing component of the base station transceiver 100. The main box 20 comprises a housing 22 for the electronic front end processing component of the base station transceiver 100 and means for attaching 24 the main box 20 to the connection box 10 with the backhaul processing component of the base station transceiver 100. Fig.1 further illustrates cooling fins 32 of the connection box 10 as well as of the main box 20, which can provide heat sinks during operation of the base station transceiver 100.

In the following different embodiments of the connection box 10 and the main box 20 will be considered. For the connection box 10 different backhaul options may exist or apply. That is to say the connection box 10 can be adapted to different backhaul needs or implementations or requirements. Moreover, different embodiments of the main box 20 will be described. The main box 20 can be adapted to different access technologies or different versions of an access technology, e.g. to WCDMA, LTE, GSM, UMTS, WLAN, WIMAX, etc.

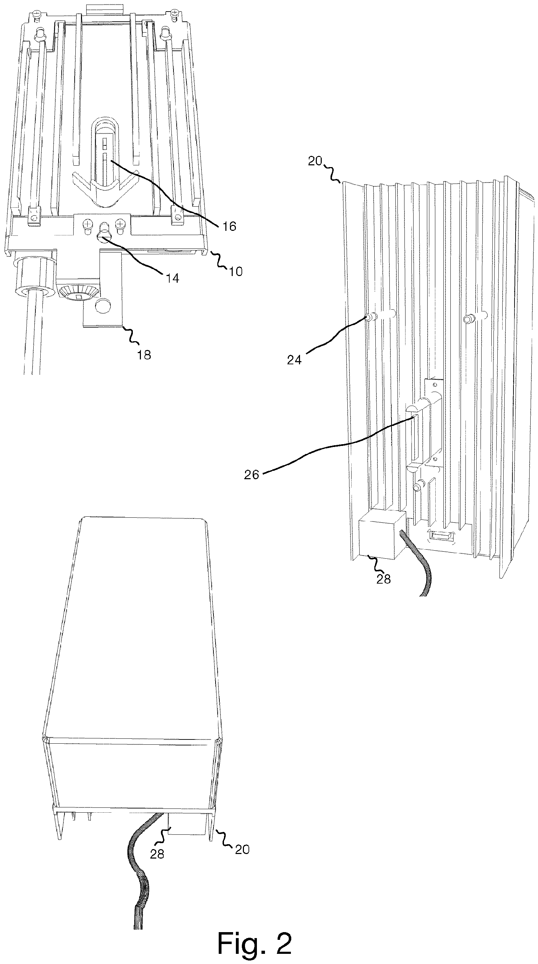

Fig. 2 further illustrates an embodiment of the connection box 10 and an embodiment of the main box 20. The main box 20 is displayed from two perspectives. The main box 20 is shown in the middle from a backside perspective, i.e. from the side which is directed towards the connection box 10, when being mounted together. The corresponding connection box 10 is shown at the top. The main box 20 comprises a common electrical connector 26 for electrically connecting the front end processing component of the base station transceiver 100 with the backhaul processing component in the connection box 10.

Fig. 2 shows the corresponding connection box 10 at the top. At the bottom of Fig. 2 the main box 20 is shown from the side, which, in the mounted condition, hides or is turned away from the connection box 10. The connection box 10 comprises a common electrical connector 16 for electrically connecting the backhaul processing component of the base station transceiver 100 with the front end processing component in the main box 20. Both the connection box 10 and the main box 20 are formed of aluminum (the cover/radome 22 can be made of synthetic material with good RF characteristics).

In the embodiment of Fig. 2, the common electrical connector 16 is operable to receive supply power from the main box 20. This is indicated by the power cable and connector 28, which is attached to the main box 20 in Fig. 2. In the embodiment, the main box 20 comprises a power supply connector 28. The common electrical connector 26 of the main box 20 is operable to provide supply power to the connection box 10. In some embodiments, one of which will be shown in more detail subsequently, the common electrical connector 26 corresponds to a PCIe connector and the common electrical connector 16 of the connection box 10 also corresponds to a PCIe connector. In such an embodiment an intermediate board can be used to connect the two connectors 16, 26.

In further embodiments, the common electrical connector 26 can be operable to connect to different backhaul processing components in different connection boxes 10, and, correspondingly, the common electrical connector 16 can be operable to connect to different front end processing components in different main boxes 20.

As can be seen from Figs. 1 and 2 the embodiment of the connection box 10 further comprises mounting equipment 18 for being mounted on a pole or wall. Moreover, the means for mounting 14 of the connection box 10 allows for mounting of main boxes 20 of different sizes, main boxes 20 with radio front ends having different frequencies, or main boxes 20 of different radio standards. Thus, the means for mounting 14 can be adapted to be combined with different main boxes 20. And furthermore, a main box 20 may be combined with different connection boxes 10 as well. Hence, the means for attaching 24 may allow for mounting of connection boxes 10 of different sizes.

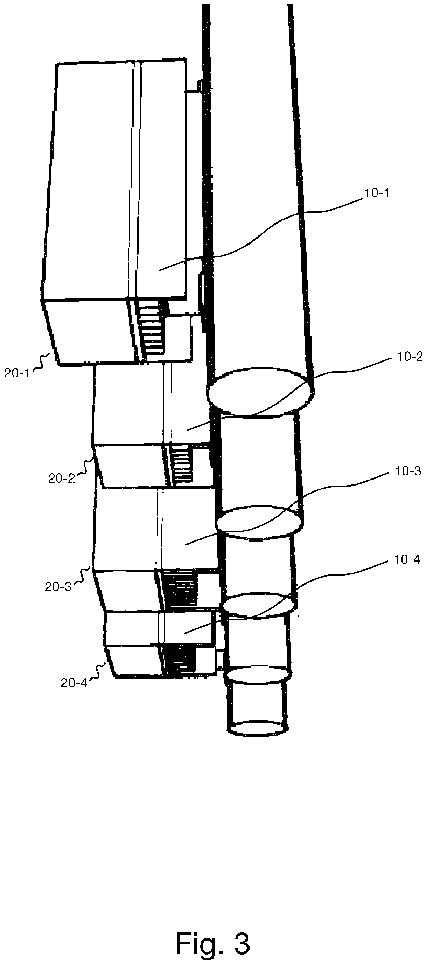

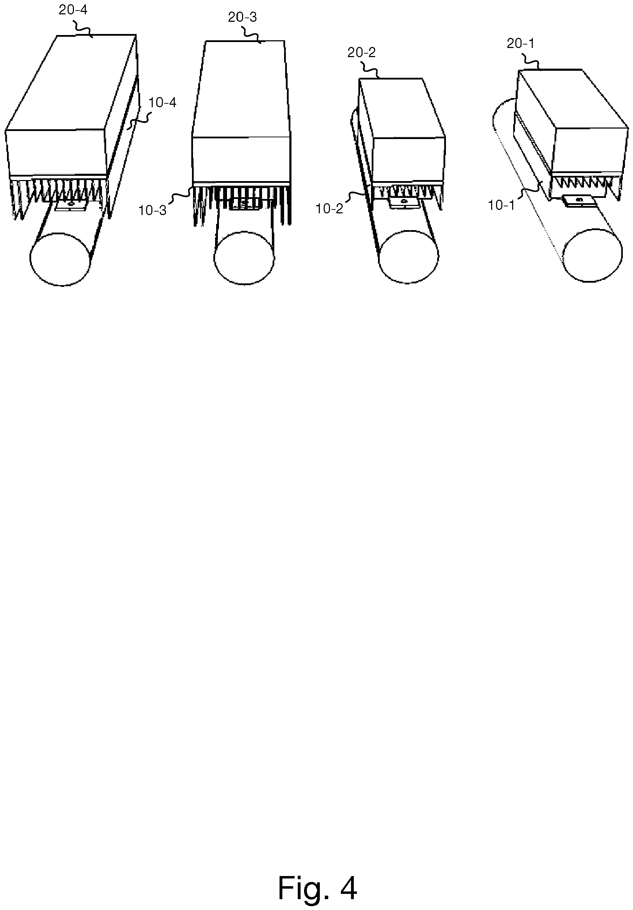

As has been mentioned above, the main box 20 may comprise an electronic front end processing component of the base station transceiver 100, for example, operating at 700MHz, 850MHz, the Advanced Wireless Service (AWS), 1.8GHz, 1.9GHz, 2.1GHz, or 2.6GHz, being compliant to one of WCDMA, LTE, GSM, UMTS, WLAN or WIMAX, or utilizing a horizontal radiation pattern with 60°, 90°, 180°, or 270° horizontal opening. Moreover, the volume or room of the main box 20 may differ, e.g. 3-131 or dm³. In some embodiments the predominant deployment is expected on light poles, the shape of the metro may then be vertically oriented. The width may not be much larger than a usual lighting pole. Figs. 3 and 4 shall illustrate different configurations or combinations of embodiments. Both figures show a selection of different embodiments of connection boxes 10-1, 10-2, 10-3, 10-4, which are combined with different main boxes 20-1, 20-2, 20-3, 20-4. All embodiments are shown in a mounted state on a pole.

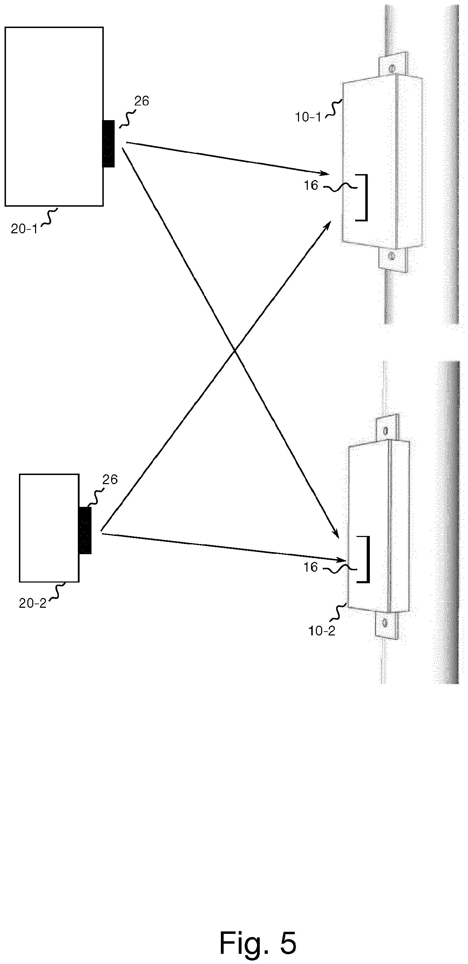

Fig. 5 illustrates two embodiments of main boxes 20-1 and 20-2 both having the same common electrical connector 26. Moreover Fig. 5 illustrates two embodiments of connection boxes 10-1 and 10-2, which are both mounted on a pole and which both comprise the same common electrical connector 16. The common electrical connectors on the main box 20 side and on the connection box 10 side may be identical, e.g. they may correspond to PCIe connectors. In other embodiments they may be different, they may, for example, correspond to a plug and a socket. In such embodiments the main boxes 20-1 and 20-2 may have the same plug, and the connection boxes 10-1 and 10-2 may have the same socket, vice versa respectively. Fig. 5 illustrates that the different main boxes 20-1 and 20-2 may be attached to either of the different connection boxes 10-1 and 10-2, which is indicated by the different arrows. In other words, the modular concept of embodiments may enable seamless combinations of different front ends in main boxes 20 and backhauls in connection boxes 10. On the mechanical side the means for mounting 14 at the connection box 10 and the means for attaching 24 at the main box 20 may be adapted to each other, such that the combinations are also mechanically enabled. In other words, in embodiments common mechanical and electrical interfaces can be used.

Figs. 3-5 show the principle of the flexibility concept, which can be realized using embodiments. Small 20-land large 20-2 main boxes 20 can be used with thin 10-1 or thick 10-2 connection boxes 10. For example, a rather thick connection box 10-1 may have additional Data Over Cable Service Interface Specification (DOCSIS) or Digital Subscriber Line (DSL) connections. A thin connection box 10-2 may, for example, connect using a Passive Optical Network (PON), Gigabit-capable Passive Optical Networks (GPON), Gigabit Ethernet Passive Optical Network, GEPON (GEPON), Wifi-Backhaul (Wifi-BH), etc.

In embodiments, it is also possible to have a wide base connection box 10 (T-shape), or a longer box 10. In embodiments cables can be hidden behind the main box 10. Embodiments also provide the base station transceiver 100 comprised of a connection box 10 and a main box 20 according to the above. In some embodiments, the connection box 10 can be hidden behind the main box 20. That is to say, from a perspective, in which the connection box 10 lies behind the main box 20 the connection box 10 can be completely hidden or shielded by the main box 20.

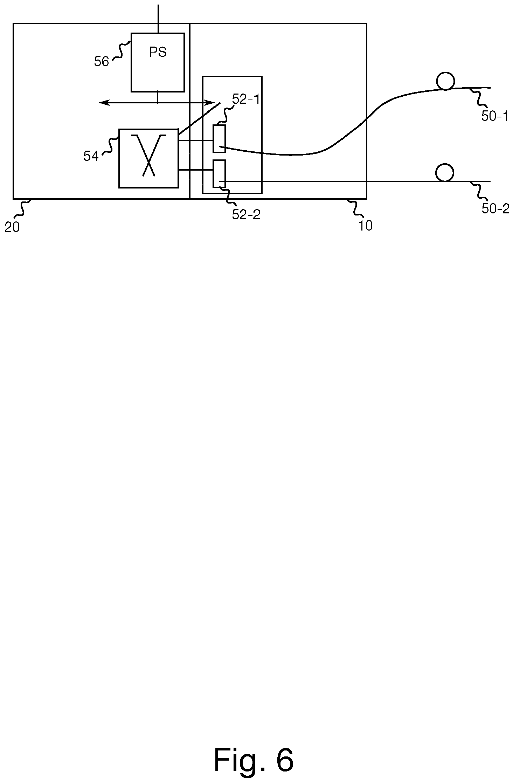

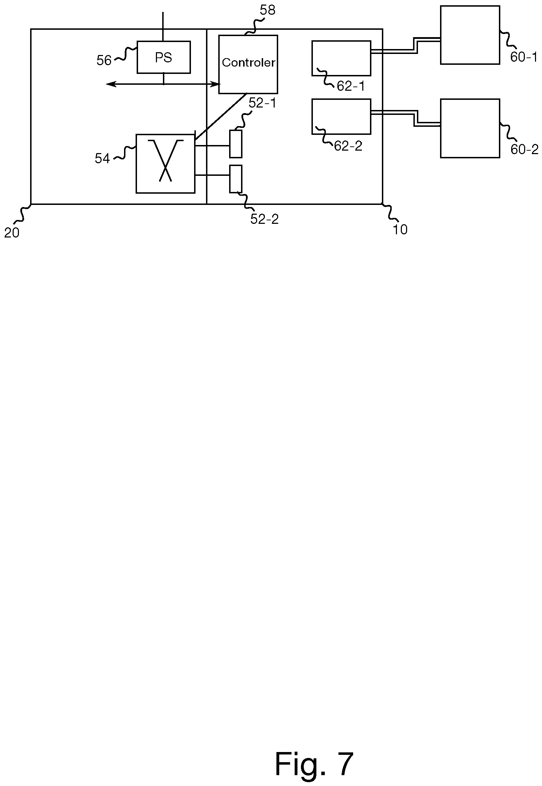

The following Figs. 6 and 7 illustrate the functional split between the connection box 10 and the main box 20 in some embodiments. Fig. 6 shows an embodiment of a main box 20 on the left hand side and an embodiment of a connection box 10 on the right hand side. The embodiment of the connection box 10 comprises two Gigabit Ethernet optical links, 50-1 and 50-2, which can be connected to two Small Form-factor Pluggable transceivers (SFP) 52-1 and 52-2, i.e. hot-pluggable transceivers for optical fiber. The embodiment of the main box 20 is implemented as a metro 3G/4G main box 20, which further comprises an Ethernet switch 54 for connecting to the connection box 10. Moreover, the main box 20 comprises a power supply 56, which is connected to an external power line and provides power to the main box 20 and connection box 10.

The power supply 56 of the main box 20 supplies also the connection box 10 in the present embodiment. This allows a single external power supply connection and avoids having Alternating Current (AC) in the connection box 10. Furthermore, it may avoid duplicated AC conditioning, such as fusing, surge protection, etc. Moreover, it may lower cost and development effort for the connection box 10 significantly and it may lower the power dissipation of the connection box 10. Such an embodiment may further allow a single, non-safety relevant, low cost connector between main box 20 and connection box 10.

Fig. 7 illustrates a similar embodiment as Fig. 6. The connection box 10 comprises a controller 58, which is connected to the Ethernet switch 54 of the main box 20. Moreover, the embodiment of Fig. 7 comprises two Wifi modules 62-1 and 62-2, which are connected to two x-polarized antennas 60-1 and 60-2. The embodiment shows a connection box 10 for Wifi (point to point) backhauling. For BTS chains, two Wifi radios or modules 62-1 and 62-2 are built in. For the connection to the Wifi chain, a wired access (SFP modules 52-1 and 52-2 for gigabit Ethernet) is also built in.

In further embodiments the connection box 10 may contain a single DOCSIS modem, or a dual port Very-high-bit-rate digital subscriber line 2nd generation (VDSL2) modem. The second VDSL2 port can be used to increase the data rate and/or resilience against link failures. Chaining may not be useful for DSL deployment because the data rate is not very high, and VDSL lines are intended for star type backhauling. For DOCSIS deployments, chaining is may not be useful because the cable can be easily connected to each base station directly, with less effort and possibly better data rate than with chaining.

A further embodiment may dimension the connection between main box 20 and the connection box 10 for up to 30W, so that low power base stations, which are Power over Ethernet (PoE, PoE+) compatible (25W) can be fed from the connection box 10. WiFi backhauling can then be expected to be directly connected to the PoE switch, if there is not enough power available from PoE to supply main box 20 and backhaul. Main boxes 20 with up to 25W power allow powering from the connection box 10, without damaging the Power Supply (PS) or having the internal PS drawing power. The PoE PS can be made safe against overload due to wrong (high power) base station or Metro being plugged. PoE configurations may not be intended for chaining in the connection box 10 - a central PoE Ethernet switch may be used for this.

In yet another embodiment a Wifi access point can be connected to the Metro, i.e. the connection box 10 of the base station transceiver 100. Some operator might choose their own Wifi Access Point (AP), or require special Wifi AP for some locations. Wifi AP are usually powered with PoE. To avoid a separate PoE injector, the PoE injector can be realized in the connection box 10, together with 10/100/1000 BaseT interface for the Wifi-AP. In case of a PoE powered Metro, the Wifi AP is separately connected to the PoE Power Device (PD).

In the following the connection between main box 20 and connection box 10 will be detailed. In embodiments, the connection can be a blind mate connection and it can be water proof. The connection mechanism may allow significant tolerances in all three dimensions. The connection can also be easily replaceable in case of damage. As has already been mentioned above PCIe- connectors 16, 26 and an intermediate board can be used in embodiments. Fig. 8 illustrates a further embodiment of a base station transceiver 100. The main box 20 is shown at the top. It comprises a printed circuit board 120 and the common electrical connector 26, which is implemented as PCIe connector. The PCIe connector 26 is surrounded or protected by a dome 122. That is to say, the dome 122 is located around the common electrical connector 26, in further embodiments a gasket can also be located around the common electrical connector 26. The dome 122 can be round or oval-shaped. In the present embodiment the connection box 10, which is shown at the bottom, also comprises a dome 112, which is located on the cover 118 of the connection box 10 around the common electrical connector 16. Moreover, a gasket 114 is located around the common electrical connector 16, which is mounted onto the backhaul electronics 116 or printed circuit board of the connection box 10. As can be seen form Fig. 8, the gasket 114 is located between the dome 122 of the main box 20 and the dome 112 of the connection box 10. The dome 122 or the cover (small dome 112) of the connection box 10 may have the gasket 114 attached to it.

The embodiment of the base station transceiver 100 shown in Fig. 8 further comprises an intermediate board 130, which is coupled to the common electrical connector 16 of the connection box 10 and which is coupled to the common electrical connector 26 of the main box 20. The intermediate board 130 is located in the middle of the domes 112, 122 and connects the two common electrical connectors 16 and 26. The dome 122 is placed around the interconnection board 130. The dome 122 is mounted in a water proof manner on the main box 20. On the side facing away from the main box 20, the dome 122 has an opening for the interconnection board 130. The opening is wider than the interconnection board 130 thickness to allow for some tolerance in X-direction. The opening is longer than the connection part of the interconnection board 130 to allow for tolerance in Y-direction. To avoid pull-out of the interconnection board 130, it has two 'ears' 132, which are covered by the dome 122. The ears 132 may correspond to notches, lugs, or cams, which prevent the intermediate board 130 from sliding outside the dome 122, once it has been inserted. The housing of the connection box 10 and the housing of the main box 20 form a waterproof surrounding for the intermediate board 132 together with the respective domes 112, 122.

The intermediate board 120 may comprise some backhaul data lines, e.g. a Serial Gigabit Media Independent Interface (SGMII), power supply, e.g. 3.3V, 5V or 12 V, some control signals for basic management of the optical (SFP) modules and for inventory management, e.g. Inter-Integrated Circuit (I²C), two-wire interface, etc.

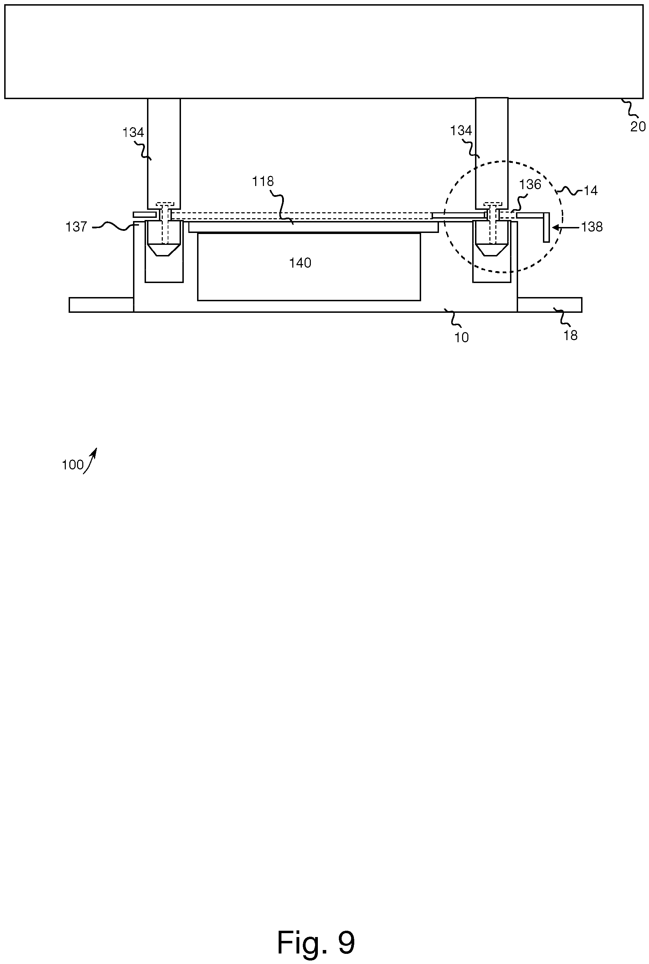

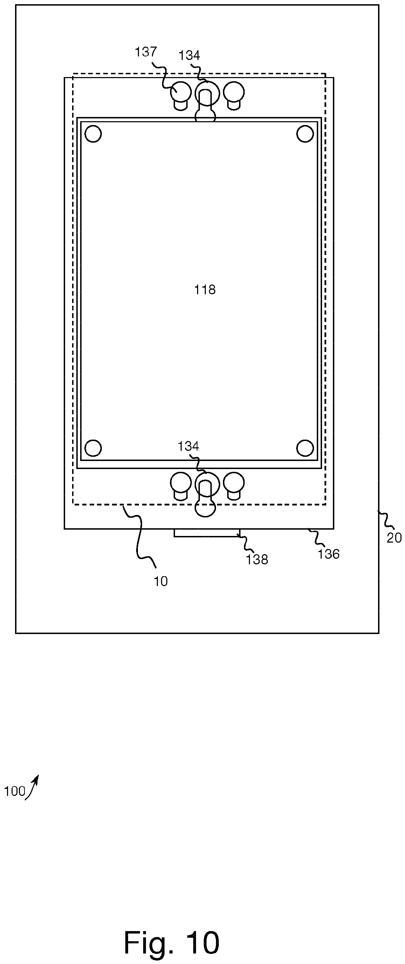

In the following more details on the mounting of the connection box 10 and the main box 20 will be provided using the embodiments depicted in Figs. 9 and 10. Fig. 9 shows another embodiment of a base station transceiver 100 comprising a main box 20 at the top and a connection box 10 at the bottom. The connection box 10 comprises mounting equipment 18 for being mounted on a pole or wall in line with the above described embodiments. The housing of the connection box 10 provides room 140 for electronic backhaul processing components of the base station transceiver 100. The room 140 is covered by a cover 118 of the connection box 10. The means for mounting 14 comprises a part 136 of a locking mechanism for the main box 20. The locking mechanism is partly comprised by the connection box 10 and partly comprised by the main box 20. That is to say, the means for attaching 24 of the main box 20 also comprises a part of a locking mechanism 134, which is implemented as studs 134, for the connection box 10. The studs 134 comprise a slot, in which a locking plate 136, which is attached to the connection box 10, can engage. The locking plate 136 is mounted to the connection box 10 via a spring mechanism and a fixation 137, such that the locking plate 136 can be moved relatively to the connection box 10 using the lever 138. The locking plate 136 corresponds to a gauge, which fits two holes in the connection box 10, in which the two studs 134 of the main box 20 can engage. Once the studs are engaged the locking plate 136 moves into the slots of the studs 134 and they are locked, such that the main box 20 is fixated to the connection box 10. By pressing the lever 138 the locking plate 136 can be disengaged, the studs 134 are freed, and the main box 20 can be removed. Thus, the locking mechanism establishes a mechanical guidance before the electrical connectors 16, 26, 130 engage.

Fig. 9 illustrates an example of the locking mechanism on a section from the side through the middle of the connection box 10. For reasons of a better overview, the spring to hold the locking plate and a safety-screw are not shown. The electrical interconnection to the main box 20 is also not shown.

Fig. 10 shows the locking mechanism from the front side. Fig. 10 shows the embodiment of the base station transceiver 100 with the connection box 10 (in a broken line) and the main box 20. In the center the cover 118 of the connection box 10 can be seen. Moreover, Fig. 10 shows two studs 134, one at the top and one at the bottom of the connection box 10. The embodiment of Fig. 10 shows two fixing studs 134, in further embodiments, for example, three (e.g. two at the top and one bottom) or four studs (one in each corner) could be used as well. Moreover, Fig. 10 shows the locking plate 136, the lever 138 and the fixation of the locking plate 137. In further embodiments the locking plate can comprise a lock, such that the locking plated can be locked, e.g. with a key, in order to prevent unauthorized disassembly of the main box 20.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A connection box (10) of a base station transceiver (100) for connecting a backhaul processing component of the base station transceiver (100) to a backhaul access system of a mobile communication system, the connection box (10) comprising
a housing (12) for an electronic backhaul processing component of the base station transceiver (100) of the mobile communication system;
means for mounting (14) a main box (20) with a front end processing component of the base station transceiver (100) of the mobile communication system.

2. The connection box (10) of claim 1, further comprising a common electrical connector (16) for electrically connecting the backhaul processing component of the base station transceiver (100) with the front end processing component in the main box (20).

3. The connection box (10) of claim 2, wherein the common electrical connector (16) is operable to receive supply power from the main box (20), wherein the common electrical connector (16) corresponds to a Peripheral Component Interconnect express connector, and/or wherein the common electrical connector (16) is operable to connect to different front end processing components in different main boxes (20).

4. The connection box (10) of claim 2, wherein a dome (122) is located around the common electrical connector (16) and/or wherein a gasket (124) is located around the common electrical connector (16).

5. The connection box (10) of claim 1, wherein the means for mounting (14) allows for mounting of main boxes (20) of different sizes, main boxes (20) with radio front ends having different frequencies, or main boxes (20) of different radio standards.

6. The connection box of claim 1, further comprising mounting equipment (18) for being mounted on a pole or wall, wherein the housing (12) provides room (140) for electronic backhaul processing components of a metro base station transceiver (100), and/or wherein the means for mounting (14) comprises at least a part of a locking mechanism (136) for the main box (20).

7. A main box (20) of a base station transceiver (100) for connecting a front end processing part of the base station transceiver (100) with a backhaul processing component of the base station transceiver (100), the main box (20) comprising
a housing (22) for an electronic front end processing component of the base station transceiver (100); and
means for attaching (24) the main box (20) to a connection box (10) with a backhaul processing component of the base station transceiver (100).

8. The main box (20) of claim 7, wherein the means for attaching (24) allows for mounting of connection boxes (10) of different sizes, and/or wherein the main box (20) comprises an electronic front end processing component of the base station transceiver (100) operating at 1.8 GHz, 2.1 GHz, or 2.6 GHz, being compliant to one of WCDMA, LTE, GSM, UMTS, WLAN or WIMAX, or utilizing a horizontal radiation pattern with 60°, 90°, 180°, or 270° horizontal opening.

9. The main box (20) of claim 7, further comprising a common electrical connector (26) for electrically connecting the front end processing component of the base station transceiver (100) with the backhaul processing component in the connection box (10).

10. The main box (20) of claim 7, further comprising a power supply connector (28), wherein the common electrical connector (26) is operable to provide supply power to the connection box (10), wherein the common electrical connector (26) corresponds to a Peripheral Component Interconnect express connector, and/or wherein the common electrical connector (26) is operable to connect to different backhaul processing components in different connection boxes (10).

11. The main box (20) of claim 7, wherein a dome is located around the common electrical connector (26), wherein a gasket (114) is located around the common electrical connector (26), and/or wherein the means for attaching (24) comprises at least a part of a locking mechanism (134) for the connection box (10).

12. A base station transceiver (100) comprising a connection box (10) according to claim 1 and a main box (20) according to claim 7.

13. The base station transceiver (100) of claim 12, wherein from a perspective, in which the connection box (10) lies behind the main box (20), the connection box (10) is completely hidden or shielded by the main box (20).

14. The base station transceiver (100) of claim 12, further comprising an intermediate board (130), which is coupled to the common electrical connector (16) of the connection box (10) and which is coupled to the common electrical connector (26) of the main box (20).

15. The base station transceiver (100) of claim 14, wherein the housing (12) of the connection box (10) and the housing (22) of the main box (20) form a waterproof surrounding for the intermediate board (130).
